# EUROPEAN PATENT APPLICATION

(11) **EP 4 502 466 A1**
(43) Date of publication of application: **05.02.2025**
(21) Application number: 23780470.3
(22) Date of filing: 28.03.2023
(51) Int. Cl.: F21Y 115/10, F21S 2/00, F21S 41/143, F21S 41/176, F21S 41/24, F21S 41/43, F21S 41/663, F21W 102/15

(54) **LIGHT-EMITTING DEVICE AND VEHICLE HEAD LAMP**

(30) Priority: 31.03.2022 JP 2022060414
(71) Applicant: Ichikoh Industries, Ltd., Isehara-shi, Kanagawa 259-1192 (JP)
(72) Inventor: TAKEZAWA Hatsuo, Isehara-shi, Kanagawa 259-1192 (JP)
(74) Representative: Lewis Silkin LLP
(86) International application number: PCT/JP2023/012404
(87) International publication number: WO 2023/190461

(57) **Abstract**

Provided are a light-emitting device and a vehicle head lamp capable of forming a luminance distribution while achieving less design burden and lower cost. The light-emitting device includes a light source that has a light-emitting surface from which light having a first wavelength is emitted, and a wavelength conversion unit that is disposed in a region covering an entire portion of the light-emitting surface of the light source and extending beyond the light-emitting surface. The wavelength conversion unit transmits part of the light from the light source, converts another part of the light from the light source into light having a second wavelength, and emits the light having a first wavelength and the light having a second wavelength as combined light.

## Description

### TECHNICAL FIELD

The present invention relates to a light-emitting device and a vehicle head lamp.

### BACKGROUND ART

Known light-emitting devices mounted on a vehicle include a light-emitting device including a plurality of light-emitting elements (e.g., Patent Literature 1). Patent Literature 1 describes a light-emitting device that includes light-emitting elements different in luminance to form a luminance distribution of light emitted from the light-emitting device.

### CITATION LIST

### PATENT LITERATURE

PTL 1: Japanese Unexamined Patent Application Publication No. 2019-3832

### SUMMARY OF THE INVENTION

### PROBLEMS TO BE SOLVED BY THE INVENTION

The light-emitting device described in Patent Literature 1 requires a plurality of light-emitting elements, and the luminance needs to be set for each of the plurality of light-emitting elements, thus causing a significant burden of design and cost.

The present invention has been made in view of the above, and an object of the present invention is to provide a light-emitting device and a vehicle head lamp capable of forming a luminance distribution while achieving less design burden and lower cost.

### MEANS FOR SOLVING THE PROBLEM

A light-emitting device according to the present invention includes: a light source that has a light-emitting surface from which light having a first wavelength is emitted; and a wavelength conversion unit that is disposed in a region covering an entire portion of the light-emitting surface of the light source and extending beyond the light-emitting surface, the wavelength conversion unit transmitting part of the light from the light source, converting another part of the light from the light source into light having a second wavelength, and emitting the light having a first wavelength and the light having a second wavelength as combined light.

The light-emitting device may further include a light guide portion that is disposed between the light-emitting surface and the wavelength conversion unit and guides the light from the light source to the wavelength conversion unit.

In the light-emitting device, the light guide portion may be provided in a region overlapping with an entire portion of the wavelength conversion unit as viewed in a normal direction of the light-emitting surface.

In the light-emitting device, the wavelength conversion unit may have a first portion that overlaps with the light-emitting surface of the light source as viewed in a normal direction of the light-emitting surface, a second portion that extends beyond the light-emitting surface as viewed in the normal direction of the light-emitting surface, and a light blocking portion that is disposed between the first portion and the second portion and blocks light traveling in the wavelength conversion unit.

In the light-emitting device, the light blocking portion may have a reflective surface that reflects light traveling in the wavelength conversion unit.

The light-emitting device may further include a light leakage prevention portion that surrounds sides of the light source and the wavelength conversion unit.

In the light-emitting device, the light-emitting device may include a plurality of the light sources, and the wavelength conversion unit may be provided over the plurality of light sources.

A vehicle head lamp according to the present invention includes: the light-emitting device; a support member that supports the light-emitting device; and a projection optics system that includes at least one of a lens and a reflector that forms a pattern by projecting the light emitted from the light-emitting device onto an area in front of a vehicle.

In the vehicle head lamp, the pattern may have a cutoff line, and light emitted from an end edge of a region of the wavelength conversion unit of the light-emitting device that overlaps with the light-emitting surface may correspond to part of the cutoff line.

The vehicle head lamp may further include a shade that is disposed between the light-emitting device and the lens and blocks part of the light emitted from the light-emitting device.

In the vehicle head lamp, the vehicle head lamp may include a plurality of the light-emitting devices, and the plurality of light-emitting devices may include a condensing light-emitting device that forms a condensing pattern that is part of the pattern, and a diffusion light-emitting device that forms a diffusion pattern around the condensing pattern.

### EFFECT OF THE INVENTION

The present invention provides a light-emitting device and a vehicle head lamp capable of forming a luminance distribution while achieving less design burden and lower cost.

### BRIEF DESCRIPTION OF THE DRAWINGS

[FIG. 1] FIG. 1 is a diagram illustrating an example of a vehicle head lamp according to the present embodiment.
[FIG. 2] FIG. 2 is a cross sectional view of an example of a light-emitting device.
[FIG. 3] FIG. 3 is a diagram illustrating examples of a positional relationship of a light source, a light guide portion, and a wavelength conversion unit.
[FIG. 4] FIG. 4 is a diagram illustrating light emission states of the wavelength conversion unit as viewed in a normal direction of a light-emitting surface.
[FIG. 5] FIG. 5 is a diagram illustrating an example of a light distribution pattern projected onto a virtual screen in front of a vehicle.
[FIG. 6] FIG. 6 is a diagram illustrating an example of a light distribution pattern projected onto the virtual screen in front of the vehicle.
[FIG. 7] FIG. 7 is a diagram illustrating a positional relationship of light sources, a light guide portion, and a wavelength conversion unit of a light-emitting device according to a modification.
[FIG. 8] FIG. 8 is a schematic diagram illustrating a configuration of a vehicle head lamp according to a modification.
[FIG. 9] FIG. 9 is a diagram illustrating a vehicle head lamp according to a modification.
[FIG. 10] FIG. 10 is a diagram illustrating a vehicle head lamp according to a modification.
[FIG. 11] FIG. 11 is a diagram illustrating an example of a light-emitting device according to a modification.

### MODE FOR CARRYING OUT THE INVENTION

An embodiment of the present invention will be described below with reference to the drawings. The present invention is not limited to the embodiment. Components in the following embodiment include those that can be easily replaced by those skilled in the art, or those that are substantially the same. In the following description, each of the front-rear direction, up-down direction, and right-left direction is a direction while a vehicle head lamp is attached to a vehicle, and indicates a direction as viewed from the driver's seat facing the direction of travel of the vehicle. In the present embodiment, the up-down direction is parallel to the vertical direction, and the left-right direction is the horizontal direction.

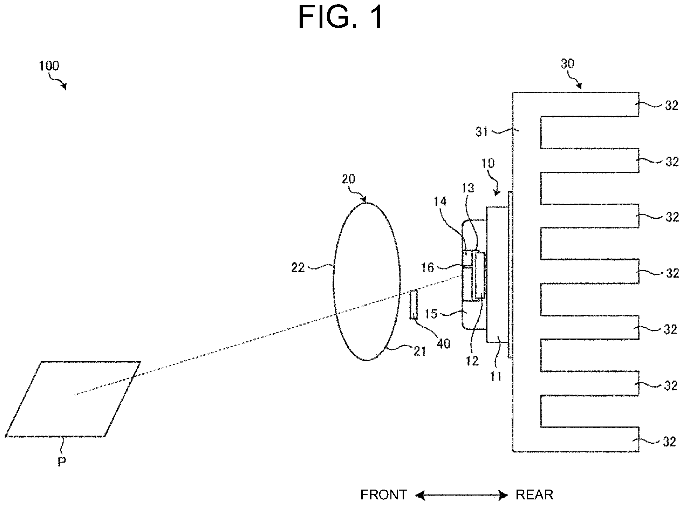

FIG. 1 is a diagram illustrating an example of a vehicle head lamp 100 according to the present embodiment. The vehicle head lamp 100 shown in FIG. 1 is housed in a lamp chamber composed of a lamp housing and a lamp lens (not shown). In addition to the lamp unit, the lamp chamber may house, for example, a clearance lamp unit, a turn signal lamp unit, a daytime running lamp unit, and the like. Furthermore, the lamp chamber may house an inner panel (not shown), an inner housing (not shown), an inner lens (not shown), and the like.

The vehicle head lamp 100 includes a light-emitting device 10, a lens (projection optics system) 20, a support member 30, and a shade 40. The vehicle head lamp 100 projects light emitted from the light-emitting device 10 onto an area in front of the vehicle through the lens 20 to form a light distribution pattern P in the area in front of the vehicle. In the present embodiment, the light distribution pattern P is, for example, a low beam pattern. The vehicle head lamp 100 may include another projection optics system such as a reflector (not shown). Furthermore, the vehicle head lamp 100 may include a reflector, instead of the lens, as a projection optics system.

The light-emitting device 10 emits white light. The lens 20 has an incident surface 21 and an emission surface 22. In the lens 20, light from the light-emitting device 10 is incident on the incident surface 21, and the light is emitted from the emission surface 22. The support member 30 supports the light-emitting device 10. The support member 30 includes a base 31 and fins 32. The light-emitting device 10 is fixed to the base 31. The fins 32 release heat generated by the light-emitting device 10. The shade 40 is disposed between the light-emitting device 10 and the lens 20. The shade 40 blocks part of light traveling from the light-emitting device 10 toward the lens 20.

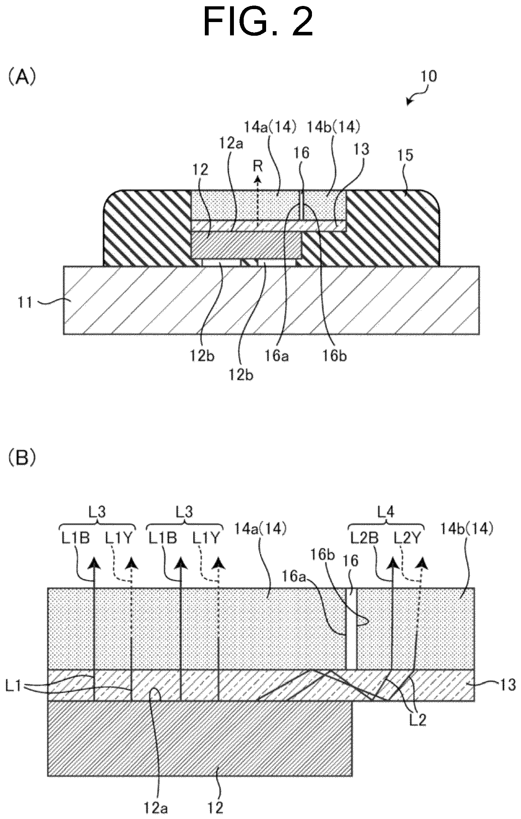

FIG. 2 is a cross sectional view of an example of the light-emitting device 10. FIG. 2 (A) is a diagram illustrating the entire light-emitting device 10, and FIG. 2 (B) is an enlarged view of a main part of the light-emitting device 10 in the FIG. 2 (A). As shown in FIGs. 2 (A) and (B), the light-emitting device 10 includes a substrate 11, a light source 12, a light guide portion 13, a wavelength conversion unit 14, a light leakage prevention portion 15, and a light blocking portion 16.

The substrate 11 is supported by the support member 30. The substrate 11 is provided with a wire, a circuit, and the like connected to the light source 12.

The light source 12 is mounted on the substrate 11. The light source 12 may be, for example, a semiconductor light source such as a light-emitting diode (LED). The light source 12 has a light-emitting surface 12a. From the light-emitting surface 12a, for example, light having, as a first wavelength, a wavelength corresponding to the wavelength of blue light is emitted. The light-emitting surface 12a is directed, for example, toward the area in front of the vehicle. In the present embodiment, the light-emitting device 10 includes, for example, a single light source 12. The light-emitting device 10 including the single light source 12 achieves lower manufacturing cost of the light-emitting device 10, less design burden of the substrate 11, and the like. The light source 12 is electrically connected to a terminal (not shown) of the substrate 11 via terminals 12b or the like.

The light guide portion 13 is disposed between the light-emitting surface 12a of the light source 12 and the wavelength conversion unit 14. The light guide portion 13 is in contact with the light-emitting surface 12a and the wavelength conversion unit 14. The light guide portion 13 may be disposed between the light-emitting surface 12a and the wavelength conversion unit 14 so that an adhesive that transmits light is held by the light guide portion 13. The light guide portion 13 guides light from the light source 12 to the wavelength conversion unit 14. The light guide portion 13 has, for example, a rectangular plate shape. The light guide portion 13 is, for example, composed of a colorless and transparent material capable of transmitting light, such as glass or a resin material.

The light guide portion 13 is disposed in a region overlapping with the entire wavelength conversion unit 14 as viewed in a normal direction R of the light-emitting surface 12a. The light guide portion 13 may overlap with the entire first portion 14a (described below) of the wavelength conversion unit 14 and part of a second portion 14b of the wavelength conversion unit 14 as viewed in the normal direction R. The light guide portion 13 may be, for example, in film form. In such a case, the light guide portion 13 may be deposited on the surface of the wavelength conversion unit 14 that faces the light source 12.

The wavelength conversion unit 14 transmits part of blue light from the light source, and converts part of the blue light from the light source into yellow light having a second wavelength. The wavelength conversion unit 14 emits white light that is combined light of the blue light transmitted through the wavelength conversion unit 14 and the yellow light obtained through conversion by the wavelength conversion unit 14. The wavelength conversion unit 14 is, for example, a phosphor member having a rectangular plate shape, and is disposed in a region covering the entire light-emitting surface 12a of the light source 12 and extending beyond the light-emitting surface 12a. The wavelength conversion unit 14 has the first portion 14a that overlaps with the light-emitting surface 12a as viewed in the normal direction of the light-emitting surface 12a, and the second portion 14b that is located outside the first portion 14a as viewed in the normal direction of the light-emitting surface 12a.

The light leakage prevention portion 15 surrounds the sides of the light source 12, the light guide portion 13, and the wavelength conversion unit 14. The light leakage prevention portion 15 is, for example, composed of a material such as resin capable of blocking light. The light leakage prevention portion 15 prevents light leakage from the sides of the light source 12, the light guide portion 13, and the wavelength conversion unit 14. The light leakage prevention portion 15 may be composed of a mixture of resin and particles that reflect light, such as titanium oxide particles.

The light blocking portion 16 is provided along a boundary portion between the first portion 14a and the second portion 14b. The light blocking portion 16 blocks light traveling in the wavelength conversion unit 14. That is, the light blocking portion 16 blocks light traveling in the first portion 14a to prevent the light from entering the second portion 14b. Furthermore, the light blocking portion 16 blocks light traveling in the second portion 14b to prevent the light from entering the first portion 14a. The light blocking portion 16 prevents light from traveling between the first portion 14a and the second portion 14b, and thus provides a clear difference in luminance between the first portion 14a and the second portion 14b. Furthermore, for example, if light incident on the first portion 14a enters the second portion 14b, the light travels a long distance in the wavelength conversion unit 14 and has a yellowish color. The light blocking portion 16 can prevent light from having a yellowish color.

The light blocking portion 16 is, for example, composed of a film made of metal such as aluminum. The light blocking portion 16 has reflective surfaces 16a and 16b. The reflective surface 16a faces the first portion 14a. Light from the inside of the first portion 14a reaches the reflective surface 16a facing the first portion 14a, and is reflected from the reflective surface 16a toward the first portion 14a. Furthermore, the reflective surface 16b faces the second portion 14b. Light from the inside of the second portion 14b reaches the reflective surface 16b facing the second portion 14b, and is reflected from the reflective surface 16b toward the second portion 14b. The reflective surfaces 16a and 16b can prevent attenuation of light traveling in the wavelength conversion unit 14. The light blocking portion 16 may not necessarily have the reflective surfaces 16a and 16b.

The wavelength conversion unit 14 including the light blocking portion 16 can be easily formed, for example, by preparing separate plate-shaped members as the first portion 14a and the second portion 14b of the wavelength conversion unit 14, vapor depositing a metal film such as an aluminum film on a side surface of the first portion 14a and a side surface of the second portion 14b, and then joining together the first portion 14a and the second portion 14b.

As shown in FIG. 2 (B), for example, a component (hereinafter referred to as light L 1) of blue light emitted from the light-emitting surface 12a of the light source 12 that is emitted along the normal direction of the light-emitting surface 12a is transmitted through the light guide portion 13, and is incident on the first portion 14a of the wavelength conversion unit 14. Furthermore, for example, part (hereinafter referred to as light L2) of a component of the blue light emitted from the light-emitting surface 12a of the light source 12 that is emitted obliquely with respect to the normal direction of the light-emitting surface 12a is guided laterally by the light guide portion 13, and is incident on the second portion 14b of the wavelength conversion unit 14.

Part of the light L1 incident on the first portion 14a of the wavelength conversion unit 14 is transmitted through the first portion 14a, and another part of the light L 1 is converted into yellow light by the first portion 14a. The light L1 is emitted as combined light L3 of blue light L1B transmitted through the first portion 14a and yellow light L1Y obtained through conversion by the first portion 14a. Furthermore, part of the light L2 incident on the second portion 14b of the wavelength conversion unit 14 is transmitted through the second portion 14b, and another part of the light L2 is converted into yellow light by the second portion 14b. The light L2 is emitted as combined light L4 of blue light L2B transmitted through the second portion 14b and yellow light L2Y obtained through conversion by the second portion 14b.

In the wavelength conversion unit 14, a larger amount of light is incident on the first portion 14a than the second portion 14b. Thus, the amount of combined light L3 is larger than the amount of combined light L4. A luminance distribution is formed when the wavelength conversion unit 14 that emits the combined light L3 and the combined light L4 is viewed in the normal direction of the light-emitting surface 12a. That is, a luminance distribution is formed so that the luminance is reduced from the first portion 14a side toward the second portion 14b side.

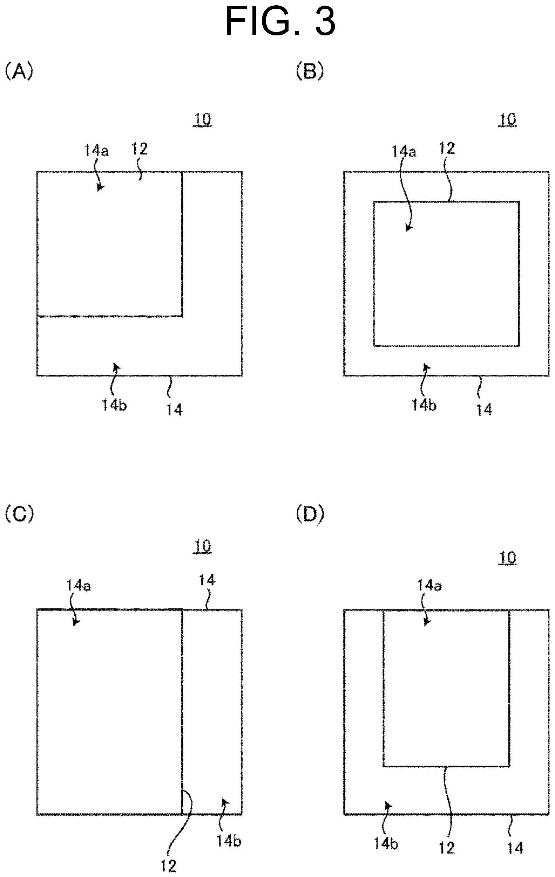

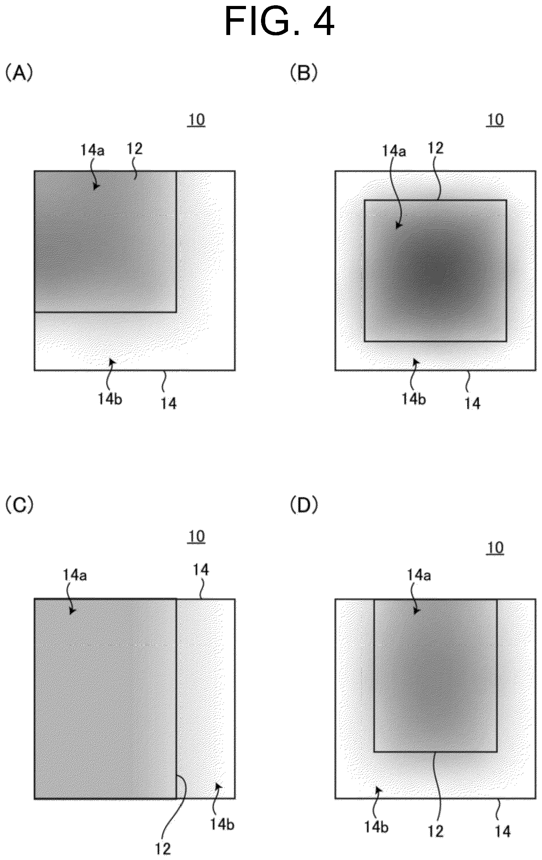

FIG. 3 is a diagram illustrating examples of a positional relationship of the light source 12, the light guide portion 13, and the wavelength conversion unit 14. FIGs. 3 (A) to (D) each show the positional relationship in the light-emitting device 10 as viewed in the normal direction of the light-emitting surface 12a. FIG. 4 is a diagram illustrating light emission states of the wavelength conversion unit 14 as viewed in the normal direction of the light-emitting surface 12a. FIGs. 4(A) to (D) show the light emission states of the wavelength conversion unit 14 of the configurations shown in FIGs. 3 (A) to (D), respectively, as viewed in the normal direction of the light-emitting surface 12a.

As shown in FIG. 3 (A), for example, the light source 12 can be disposed in plan view in a corner portion of the light guide portion 13 and the wavelength conversion unit 14. That is, the first portion 14a of the wavelength conversion unit 14 has a rectangular shape, and includes an upper left corner portion of the wavelength conversion unit 14 and part of a left edge and part of an upper edge of the wavelength conversion unit 14 in plan view. Furthermore, the second portion 14b of the wavelength conversion unit 14 has an L-shape, and is provided along a right edge and a lower edge of the wavelength conversion unit 14.

In the configuration shown in FIG. 3 (A), when light is emitted from the wavelength conversion unit 14, a luminance distribution is formed so that the luminance is reduced from the first portion 14a side toward the second portion 14b side. That is, as shown in FIG. 4 (A), a luminance distribution is formed so that the luminance is gradually reduced from the upper left side toward the right side and the lower side. In the example shown in FIG. 3 (A), the light source 12 is disposed in the upper left corner portion of the wavelength conversion unit 14; however, the present invention is not limited to this configuration, and the light source 12 may be disposed in an upper right corner portion, a lower left corner portion, or a lower right corner portion of the wavelength conversion unit 14.

As shown in FIG. 3 (B), for example, the light source 12 can be disposed in plan view in a center portion of the light guide portion 13 and the wavelength conversion unit 14. That is, the first portion 14a of the wavelength conversion unit 14 has a rectangular shape, and is located in the center portion of the wavelength conversion unit 14 in plan view. Furthermore, the second portion 14b of the wavelength conversion unit 14 is located around the first portion 14a, and is provided along the four edges of the wavelength conversion unit 14.

In the configuration shown in FIG. 3 (B), when light is emitted from the wavelength conversion unit 14, a luminance distribution is formed so that the luminance is reduced from the first portion 14a side toward the second portion 14b side. That is, as shown in FIG. 4 (B), a luminance distribution is formed so that the luminance is gradually reduced from the center portion side toward the peripheral portion side.

As shown in FIG. 3 (C), for example, the light source 12 can be disposed in plan view on one side of the light guide portion 13 and the wavelength conversion unit 14 in the up-down direction or the left-right direction. In the example shown in FIG. 3 (C), the light source 12 is disposed on the left edge side of the light guide portion 13 and the wavelength conversion unit 14. The first portion 14a of the wavelength conversion unit 14 is a region including the left edge of the wavelength conversion unit 14 in plan view. Furthermore, the second portion 14b of the wavelength conversion unit 14 is a region including the right edge of the wavelength conversion unit 14 in plan view.

In the configuration shown in FIG. 3 (C), when light is emitted from the wavelength conversion unit 14, a luminance distribution is formed so that the luminance is reduced from the first portion 14a side toward the second portion 14b side. That is, as shown in FIG. 4 (C), a luminance distribution is formed so that the luminance is gradually reduced from the left edge side toward the right edge side.

As shown in FIG. 3 (D), for example, the light source 12 can be disposed in plan view at a position that is located on one side of the light guide portion 13 and the wavelength conversion unit 14 in the up-down direction and located in a center portion of the light guide portion 13 and the wavelength conversion unit 14 with spaces on both sides in the left-right direction. In the example shown in FIG. 3 (D), the light source 12 is disposed on the upper edge side of the light guide portion 13 and the wavelength conversion unit 14. The first portion 14a of the wavelength conversion unit 14 is a region including a center portion of the upper edge of the wavelength conversion unit 14 in plan view. Furthermore, the second portion 14b of the wavelength conversion unit 14 is a region including the left edge, right edge, and lower edge of the wavelength conversion unit 14 in plan view.

In the configuration shown in FIG. 3 (D), when light is emitted from the wavelength conversion unit 14, a luminance distribution is formed so that the luminance is reduced from the first portion 14a side toward the second portion 14b side. That is, as shown in FIG. 4 (D), a luminance distribution is formed so that the luminance is gradually reduced from the center portion of the upper edge toward the left edge side, right edge side, and lower edge side.

Light emitted from the light-emitting device 10 is projected by the lens 20 onto the area in front of the vehicle while part of the light is blocked by the shade 40. In this case, a low beam pattern is formed as the light distribution pattern P in the area in front of the vehicle.

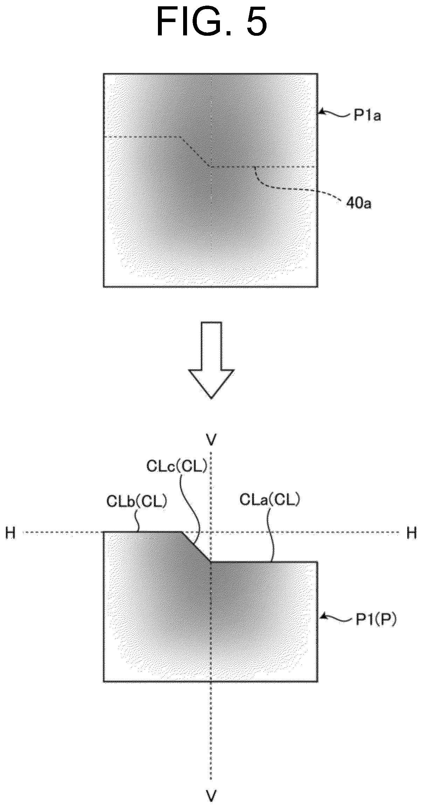

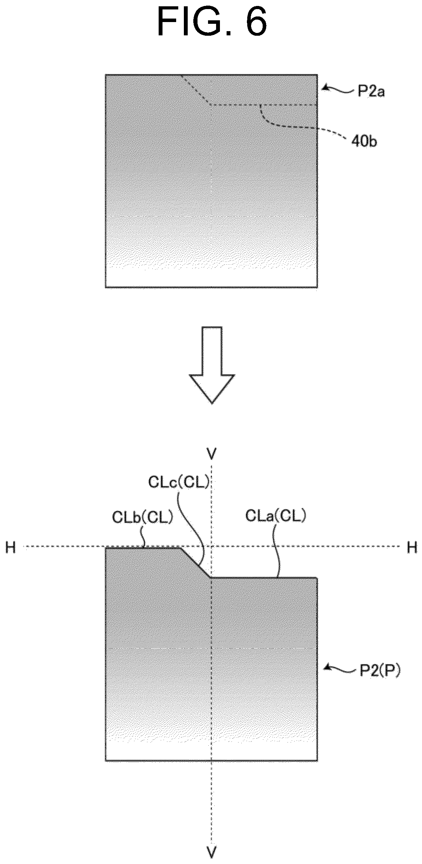

FIGs. 5 and 6 are each a diagram illustrating an example of a light distribution pattern projected onto a virtual screen in front of the vehicle. FIGs. 5 and 6 each show a light distribution pattern corresponding to a vehicle in left-hand traffic. In FIGs. 5 and 6, the V-V line indicates a vertical line of the screen, and the H-H line indicates a horizontal line in the left and right direction of the screen.

FIG. 5 shows an example of a light distribution pattern formed when the light-emitting device 10 having the configuration shown in FIG. 3 (D) is used. The light-emitting device 10 having the configuration shown in FIG. 3 (D) forms a light distribution pattern P1a shown on the upper side of FIG. 5. When a predetermined portion 40a of the light distribution pattern P1a is removed by the shade 40 or the like, a light distribution pattern P1 shown on the lower side of FIG. 5 is formed. The light distribution pattern P1 has a cutoff line CL along the horizontal line H-H. The cutoff line CL includes horizontal cutoff lines CLa and CLb and an oblique cutoff line CLc. In the light distribution pattern P1, the luminance is reduced downward from the cutoff line CL and reduced from the vertical line V-V toward both sides in the left-right direction.

FIG. 6 shows an example of a light distribution pattern formed when the light-emitting device 10 having the configuration shown in FIG. 3 (C) is disposed so that the left edge of the light-emitting device 10 is located on the upper side. The light-emitting device 10 having the configuration shown in FIG. 3 (C) forms a light distribution pattern P2a shown on the upper side of FIG. 6. When a predetermined portion 40b of the light distribution pattern P2a is removed by the shade 40 or the like, a light distribution pattern P2 shown on the lower side of FIG. 6 is formed.

The light distribution pattern P2 has a cutoff line CL along the horizontal line H-H. The cutoff line CL includes horizontal cutoff lines CLa and CLb and an oblique cutoff line CLc. In the light distribution pattern P2, the luminance is reduced downward from the cutoff line CL. In the light distribution pattern P2, light emitted from an end edge of a region of the wavelength conversion unit 14 of the light-emitting device 10 that overlaps with the light-emitting surface 12a corresponds to part of the cutoff line CL. According to this configuration, the cutoff line CL can be efficiently formed.

As described above, the light-emitting device 10 according to the present embodiment includes the light source 12 that has the light-emitting surface 12a from which light having a first wavelength is emitted, and the wavelength conversion unit 14 that is disposed in the region covering the entire light-emitting surface 12a of the light source 12 and extending beyond the light-emitting surface 12a. The wavelength conversion unit transmits part of light from the light source 12, converts another part of the light from the light source 12 into light having a second wavelength, and emits the light having a first wavelength and the light having a second wavelength as combined light.

According to this configuration, part of the wavelength conversion unit 14 extends beyond the light-emitting surface 12a; thus, when combined light is emitted from the wavelength conversion unit 14, a luminance distribution can be formed between the part of the wavelength conversion unit 14 that covers the light-emitting surface 12a and the part of the wavelength conversion unit 14 that extends beyond the light-emitting surface 12a. Therefore, a luminance distribution can be formed without changing the configuration of the light source 12. This makes it possible to provide the light-emitting device 10 capable of forming a luminance distribution while achieving less design burden and lower cost.

The light-emitting device 10 according to the present embodiment further includes the light guide portion 13 that is disposed between the light-emitting surface 12a and the wavelength conversion unit 14 and guides light from the light source 12 to the wavelength conversion unit 14. According to this configuration, light emitted from the light-emitting surface 12a can be efficiently incident on the wavelength conversion unit 14.

In the light-emitting device 10 according to the present embodiment, the light guide portion 13 is provided in the region overlapping with the entire wavelength conversion unit 14 as viewed in the normal direction of the light-emitting surface 12a. According to this configuration, light emitted from the light-emitting surface 12a can be efficiently incident on the entire wavelength conversion unit 14 including both the part (first portion 14a) of the wavelength conversion unit 14 that covers the light-emitting surface 12a and the part (second portion 14b) of the wavelength conversion unit 14 that extends beyond the light-emitting surface 12a.

In the light-emitting device 10 according to the present embodiment, the wavelength conversion unit 14 has the light blocking portion 16 that blocks light traveling in the wavelength conversion unit 14 and is located between the first portion 14a corresponding to the light-emitting surface 12a and the second portion 14b located outside the first portion 14a. For example, if light incident on the first portion 14a enters the second portion 14b, the light travels a long distance in the wavelength conversion unit 14; thus, a high proportion of the light is converted into yellow light. This causes light emitted from the second portion 14b to have a high intensity of yellow. According to the above configuration, it is possible to prevent the entry of light from the first portion 14a into the second portion 14b, thus preventing the emission of light having a high intensity of yellow from the second portion 14b.

In the light-emitting device 10 according to the present embodiment, the light blocking portion 16 has the reflective surfaces 16a and 16b that reflect light. According to this configuration, the reflective surfaces 16a and 16b reflect light to prevent the light blocking portion 16 from absorbing light, thus preventing lower light use efficiency.

The light-emitting device 10 according to the present embodiment further includes the light leakage prevention portion 15 that surrounds the sides of the light source 12 and the wavelength conversion unit 14. According to this configuration, it is possible to prevent light leakage from the sides of the light source 12 and the wavelength conversion unit 14.

The vehicle head lamp 100 according to the present embodiment includes the light-emitting device 10, the support member 30 that supports the light-emitting device 10, and the lens 20 that forms the light distribution pattern P in the area in front of the vehicle by projecting light emitted from the light-emitting device 10 onto the area in front of the vehicle. According to this configuration, due to the light-emitting device 10 capable of forming a luminance distribution while achieving less design burden and lower cost, it is possible to form a brightness distribution as the light distribution pattern P without using a configuration that includes a plurality of light sources and in which the luminance is set for each of the light sources. This makes it possible to provide the vehicle head lamp 100 that achieves less design burden and lower cost.

In the vehicle head lamp 100 according to the present embodiment, the light distribution pattern P has the cutoff line CL, and light emitted from the end edge of the region of the wavelength conversion unit 14 of the light-emitting device 10 that overlaps with the light-emitting surface 12a corresponds to part of the cutoff line CL. According to this configuration, the cutoff line CL can be efficiently formed.

The vehicle head lamp 100 according to the present embodiment further includes the shade 40 that is disposed between the light-emitting device 10 and the lens 20 and blocks part of light emitted from the light-emitting device 10. According to this configuration, the shade 40 can easily form an outline of the light distribution pattern P such as the cutoff line CL.

The technical scope of the present invention is not limited to the above embodiment, and can be modified as appropriate without departing from the spirit of the present invention. For example, in the example described in the above embodiment, the light-emitting device 10 includes the single light source 12; however, the present invention is not limited to this configuration. The light-emitting device 10 may include a plurality of light sources 12.

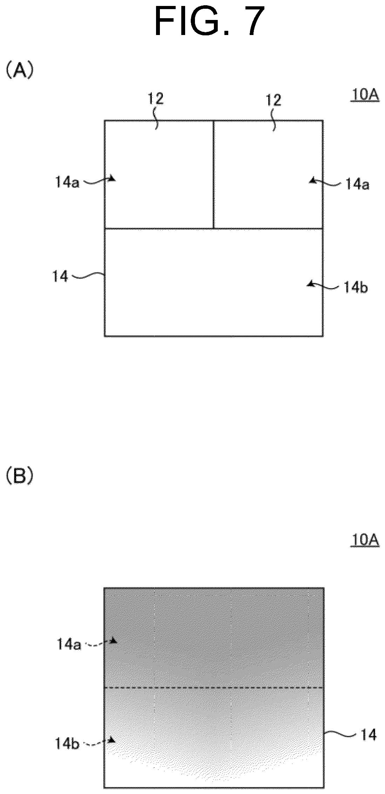

FIG. 7 is a diagram illustrating a positional relationship of light sources 12, the light guide portion 13, and the wavelength conversion unit 14 of a light-emitting device 10A according to a modification. FIG. 7 (A) shows the positional relationship in the light-emitting device 10 as viewed in the normal direction of the light-emitting surface 12a. FIG. 7 (B) shows a light emission state of the wavelength conversion unit 14 as viewed in the normal direction of the light-emitting surface 12a when light (blue light) is emitted from the light-emitting surface 12a. The light-emitting device 10A shown in FIGs. 7 (A) and (B) includes a plurality of light sources 12, and the light guide portion 13 and the wavelength conversion unit 14 are provided over the plurality of light sources 12. According to this configuration, the plurality of light sources 12 can provide a larger amount of light. Furthermore, the wavelength conversion unit 14 provided over the plurality of light sources 12 achieves lower manufacturing cost as compared with the case where a separate wavelength conversion unit 14 is provided for each of the light sources 12.

In the example described in the above embodiment, the single vehicle head lamp 100 includes the single light-emitting device 10; however, the present invention is not limited to this configuration. The single vehicle head lamp 100 may include a plurality of light-emitting devices.

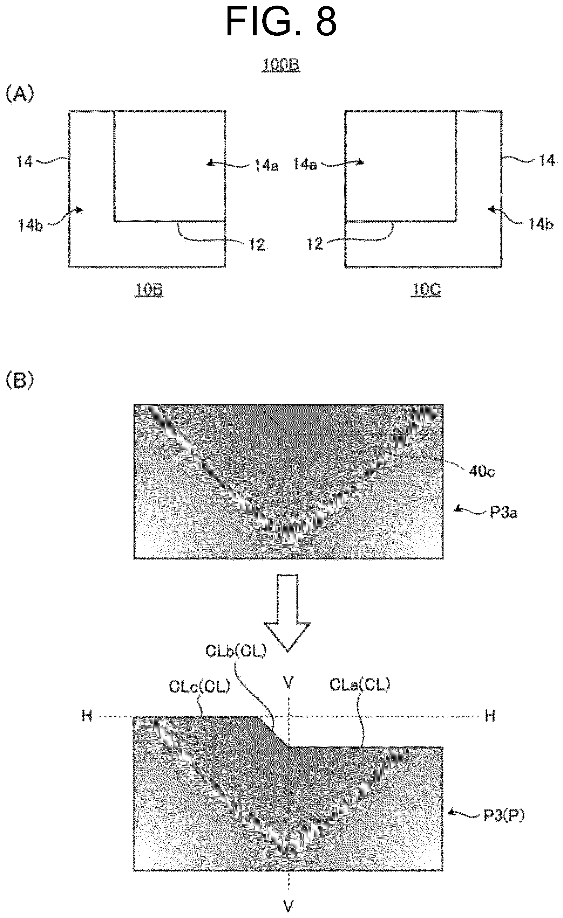

FIG. 8 is a schematic diagram illustrating a configuration of a vehicle head lamp 100B according to a modification. FIG. 8 (A) shows a positional relationship of light-emitting devices 10B and 10C of the vehicle head lamp 100B as viewed in the normal direction of the light-emitting surface 12a. As shown in FIG. 8 (A), the vehicle head lamp 100B may include, for example, the two light-emitting devices 10B and 10C. In the light-emitting device 10B, the light source 12 is disposed in an upper right corner portion of the wavelength conversion unit 14. In the light-emitting device 10C, the light source 12 is disposed in an upper left corner portion of the wavelength conversion unit 14.

FIG. 8 (B) is a diagram illustrating an example of a light distribution pattern projected from the vehicle head lamp 100B onto the virtual screen in front of the vehicle. As shown in FIG. 8 (B), the light-emitting devices 10B and 10C used in combination forms a light distribution pattern P3a shown on the upper side of FIG. 8 (B). When a predetermined portion 40c of the light distribution pattern P3a is removed by the shade 40 or the like, a light distribution pattern P3 shown on the lower side of FIG. 8 (B) is formed. The light distribution pattern P3 is a low beam pattern. The light distribution pattern P3 has a cutoff line CL along the horizontal line H-H due to the shade 40. In the light distribution pattern P3, the luminance is reduced downward from the cutoff line CL and reduced from the vertical line V-V toward both sides in the left-right direction. In the light distribution pattern P3, light emitted from an end edge (upper edge) of a region of the wavelength conversion unit 14 of the light-emitting device 10B that overlaps with the light-emitting surface 12a corresponds to part of the cutoff line CL. The light distribution pattern P3 is formed using the two light-emitting devices 10B and 10C, and thus has a larger amount of light than a light distribution pattern formed using a single light-emitting device 10. This makes it possible to obtain a bright light distribution pattern P3.

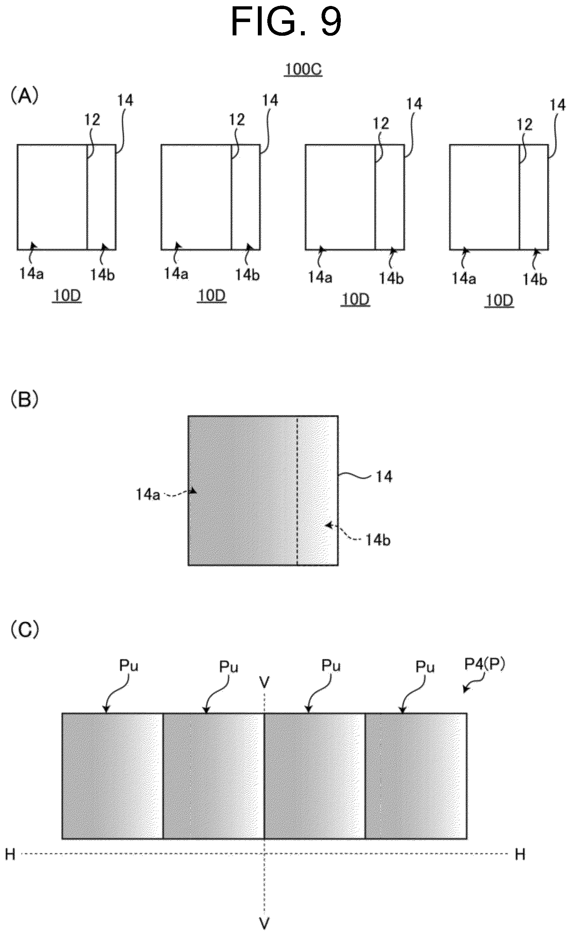

FIG. 9 is a diagram illustrating a vehicle head lamp 100C according to a modification. FIG. 9 (A) is a schematic diagram illustrating a configuration of the vehicle head lamp 100C according to the modification. As shown in FIG. 9 (A), the vehicle head lamp 100D includes, for example, four light-emitting devices 10D. In each of the light-emitting devices 10D, for example, the light source 12 can be disposed on one side of the light guide portion 13 and the wavelength conversion unit 14 in the left-right direction. In the example shown in FIG. 9, the light source 12 is disposed on the left edge side of the light guide portion 13 and the wavelength conversion unit 14.

FIG. 9 (B) shows a light emission state of the wavelength conversion unit 14 as viewed in the normal direction of the light-emitting surface 12a in one of the light-emitting device 10D. As shown in FIG. 9 (B), when light is emitted from the light-emitting device 10D, a luminance distribution is formed so that the luminance is gradually reduced from the left edge side toward the right edge side.

FIG. 9 (C) is a diagram illustrating an example of a light distribution pattern projected from the vehicle head lamp 100C onto the virtual screen in front of the vehicle. As shown in FIG. 9 (C), the vehicle head lamp 100D can form, for example, an ADB pattern as a light distribution pattern P4 using the four light-emitting devices 10D. In the light distribution pattern P4, individual patterns (hereinafter referred to as unit patterns) Pu are each formed so that the brightness is reduced from the left edge side toward the right edge side. The left edge of the unit light distribution patterns Pu corresponds to the left edge of the wavelength conversion unit 14.

Thus, the plurality of light-emitting devices 10D used in combination can form the light distribution pattern P4 that is an ADB pattern. The turning on and off of each of the unit light distribution patterns Pu can be adjusted by controlling the light emission timing for the corresponding one of the light-emitting devices 10D.

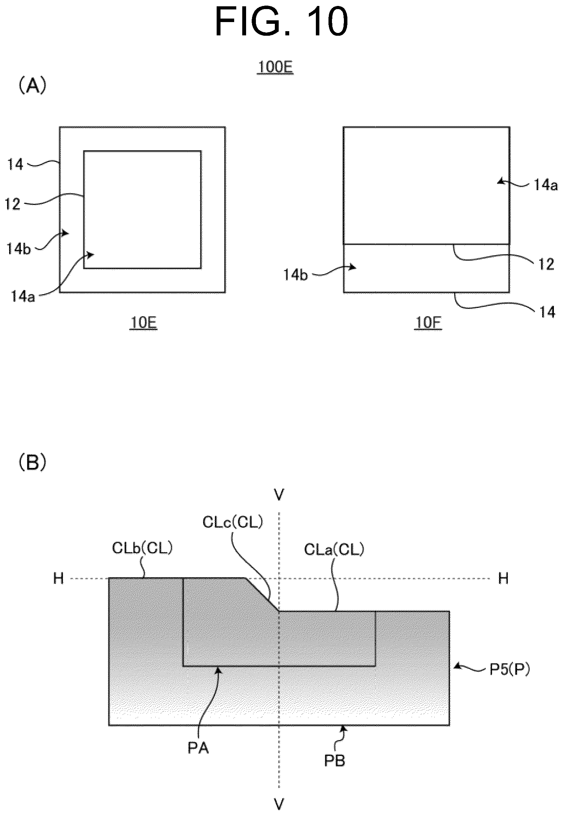

FIG. 10 is a diagram illustrating a vehicle head lamp 100E according to a modification. FIG. 10 (A) is a schematic diagram illustrating a configuration of the vehicle head lamp 100E according to the modification. As shown in FIG. 10 (A), the vehicle head lamp 100E includes, for example, a condensing light-emitting device 10E and a diffusion light-emitting device 10F. For example, as with the light-emitting device 10 shown in FIG. 3 (B), the condensing light-emitting device 10E may be a light-emitting device that forms a luminance distribution so that the luminance is reduced from the center portion toward the outer periphery of the wavelength conversion unit 14. For example, as with the light-emitting device 10 shown in FIG. 3 (C), the diffusion light-emitting device 10F may be a light-emitting device that forms a luminance distribution so that the luminance is reduced from a first side of the wavelength conversion unit 14 toward a second side of the wavelength conversion unit 14 that faces the first side. The condensing light-emitting device 10E and the diffusion light-emitting device 10F are not limited to the above light-emitting devices.

FIG. 10 (B) is a diagram illustrating an example of a light distribution pattern projected from the vehicle head lamp 100E onto the virtual screen in front of the vehicle. As shown in FIG. 10 (B), a light distribution pattern P5 is a low beam pattern. The condensing light-emitting device 10E forms a condensing light distribution pattern PA that is part of the light distribution pattern P5. Furthermore, the diffusion light-emitting device 10F forms a diffusion light distribution pattern PB that is part of the light distribution pattern P5. According to this configuration, it is possible to form the light distribution pattern P5 including the condensing light distribution pattern PA and the diffusion light distribution pattern PB having a sufficient amount of light.

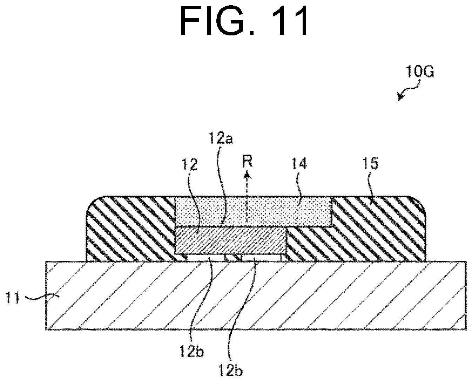

In the example described in the above embodiment, the light-emitting device includes the light guide portion 13; however, the present invention is not limited to this configuration. The light-emitting device may not necessarily include the light guide portion 13. FIG. 11 is a diagram illustrating an example of a light-emitting device 10G according to a modification. In the light-emitting device 10G shown in FIG. 11, no light guide portion is provided, and the wavelength conversion unit 14 is disposed on the light-emitting surface 12a of the light source 12 and part of the wavelength conversion unit 14 extends beyond the light-emitting surface 12a.

According to this configuration, in the light-emitting device 10G, part of the wavelength conversion unit 14 extends beyond the light-emitting surface 12a; thus, when combined light is emitted from the wavelength conversion unit 14, a luminance distribution can be formed between the part of the wavelength conversion unit 14 that covers the light-emitting surface 12a and the part of the wavelength conversion unit 14 that extends beyond the light-emitting surface 12a. Therefore, a luminance distribution can be formed without changing the configuration of the light source 12.

In the example described in the above embodiment, the shade 40 blocks part of light from the light-emitting device to form a light distribution pattern; however, the present invention is not limited to this configuration. For example, a light blocking portion that blocks light may be disposed on a surface of the light source 12, the light guide portion 13, and the wavelength conversion unit 14. Furthermore, in the light source 12, current constriction, an internal electrode array, or the like may be designed to form a non-light-emitting unit on part of the light-emitting surface 12a.

In the light-emitting device described in the above embodiment, for example, the light guide portion 13 having a large thickness allows a large amount of blue light to reach the part of the wavelength conversion unit 14 that extends beyond the light-emitting surface 12a. In this case, a large amount of blue light is incident on the second portion 14b of the wavelength conversion unit 14, and causes the second portion 14b to have high luminance. Furthermore, the light guide portion 13 having a small thickness allows a small amount of blue light to reach the part of the wavelength conversion unit 14 that extends beyond the light-emitting surface 12a. In this case, a small amount of blue light is incident on the second portion 14b of the wavelength conversion unit 14, and causes the second portion 14b to have low luminance. Thus, the luminance distribution of the combined light L3 and L4 emitted from the wavelength conversion unit 14 can be controlled by adjusting the thickness of the light guide portion 13.

In the light-emitting device described in the above embodiment, a positional relationship between the first portion 14a and the second portion 14b of the wavelength conversion unit 14 can be adjusted by adjusting the disposition of the light blocking portion 16. This makes it possible to control the luminance distribution in the wavelength conversion unit 14.

### DESCRIPTION OF REFERENCE NUMERALS

CL Cutoff line
CLa, CLb Horizontal cutoff line
CLc Oblique cutoff line
L1, L2 Light
L1B, L2B Blue light
L1Y, L2Y Yellow light
L3, L4 Combined light
P, P1, P2, P3, P4, P5, P1a, P2a, P3a Light distribution pattern
PA Condensing light distribution pattern
PB Diffusion light distribution pattern
Pu Unit light distribution pattern
R Normal direction
10, 10A, 10B, 10C, 10D, 10G Light-emitting device
10E Condensing light-emitting device
10F Diffusion light-emitting device
11 Substrate
12 Light source
12a Light-emitting surface
12b Terminal
13 Light guide portion
14 Wavelength conversion unit
14a First portion
14b Second portion
15 Light leakage prevention portion
16 Light blocking portion
16a, 16b Reflective surface
20 Lens
21 Incident surface
22 Emission surface
30 Support member
31 Base
32 Fin
40 Shade
40a, 40b, 40c Predetermined portion
100, 100B, 100C, 100D, 100E Vehicle head lamp

## Claims

1. A light-emitting device (10) comprising:
a light source (12) that has a light-emitting surface (12a) from which light having a first wavelength is emitted; and
a wavelength conversion unit (14) that is disposed in a region covering an entire portion of the light-emitting surface (12a) of the light source (12) and extending beyond the light-emitting surface (12a), the wavelength conversion unit (14) transmitting part of the light from the light source (12), converting another part of the light from the light source (12) into light having a second wavelength, and emitting the light having a first wavelength and the light having a second wavelength as combined light.

2. The light-emitting device (10) according to claim 1, further comprising
a light guide portion (13) that is disposed between the light-emitting surface (12a) and the wavelength conversion unit (14) and guides the light from the light source (12) to the wavelength conversion unit (14).

3. The light-emitting device (10) according to claim 2, wherein
the light guide portion (13) is provided in a region overlapping with an entire portion of the wavelength conversion unit (14) as viewed in a normal direction of the light-emitting surface (12a).

4. The light-emitting device (10) according to claim 1, wherein
the wavelength conversion unit (14) has a first portion (14a) that overlaps with the light-emitting surface (12a) of the light source (12) as viewed in a normal direction of the light-emitting surface (12a), a second portion (14b) that extends beyond the light-emitting surface (12a) as viewed in the normal direction of the light-emitting surface (12a), and a light blocking portion (16) that is disposed between the first portion (14a) and the second portion (14b) and blocks light traveling in the wavelength conversion unit (14).

5. The light-emitting device (10) according to claim 4, wherein
the light blocking portion (16) has a reflective surface (16a, 16b) that reflects light traveling in the wavelength conversion unit (14).

6. The light-emitting device (10) according to claim 1, further comprising
a light leakage prevention portion (15) that surrounds sides of the light source (12) and the wavelength conversion unit (14).

7. The light-emitting device (10) according to claim 1, wherein
the light-emitting device (10) comprises a plurality of the light sources (12), and
the wavelength conversion unit (14) is provided over the plurality of light sources (12).

8. A vehicle head lamp (100) comprising:
the light-emitting device (10) according to claim 1;
a support member (30) that supports the light-emitting device (10); and
a projection optics system (20) that includes at least one of a lens and a reflector that forms a pattern by projecting the light emitted from the light-emitting device (10) onto an area in front of a vehicle.

9. The vehicle head lamp (100) according to claim 8, wherein
the pattern has a cutoff line, and
light emitted from an end edge of a region of the wavelength conversion unit (14) of the light-emitting device (10) that overlaps with the light-emitting surface (12a) corresponds to part of the cutoff line.

10. The vehicle head lamp (100) according to claim 8, further comprising
a shade (40) that is disposed between the light-emitting device (10) and the lens and blocks part of the light emitted from the light-emitting device (10).

11. The vehicle head lamp (100) according to claim 8, wherein
the vehicle head lamp (100) comprises a plurality of the light-emitting devices (10), and
the plurality of light-emitting devices (10) include a condensing light-emitting device (10E) that forms a condensing pattern that is part of the pattern, and a diffusion light-emitting device (10F) that forms a diffusion pattern around the condensing pattern.
